# EUROPEAN PATENT SPECIFICATION

(11) **EP 2 602 822 B1**
(45) Date of publication and mention of the grant of the patent: **19.01.2022**
(21) Application number: 11814426.0
(22) Date of filing: 14.07.2011
(51) Int. Cl.: H01L 21/336, H01L 29/04, H01L 29/78, H01L 29/739, H01L 29/423, H01L 29/06, H01L 29/12, H01L 29/16, H01L 29/861

(54) **SEMICONDUCTOR DEVICE AND PROCESS FOR PRODUCTION THEREOF**
HALBLEITERVORRICHTUNG UND HERSTELLUNGSVERFAHREN DAFÜR
DISPOSITIF À SEMI-CONDUCTEUR ET SON PROCÉDÉ DE FABRICATION

(30) Priority: 03.08.2010 JP 2010174663
(43) Date of publication of application: 12.06.2013
(73) Proprietor: Sumitomo Electric Industries, Ltd., Chuo-ku Osaka-shi Osaka 541-0041 (JP)
(72) Inventor: MASUDA, Takeyoshi, Osaka-shi Osaka 554-0024 (JP); HARADA, Shin, Osaka-shi Osaka 554-0024 (JP); HONAGA, Misako, Osaka-shi Osaka 554-0024 (JP); WADA, Keiji, Osaka-shi Osaka 554-0024 (JP); HIYOSHI, Toru, Osaka-shi Osaka 554-0024 (JP)
(74) Representative: Grünecker Patent- und Rechtsanwälte PartG mbB
(86) International application number: PCT/JP2011/066063
(87) International publication number: WO 2012/017796

(56) References cited:
- EP-A2- 1 705 696
- WO-A1-94/13017
- JP-A- 7 326 755
- JP-A- 9 199 724
- JP-A- 2002 261 275
- JP-A- 2002 261 280
- JP-A- 2002 359 378
- JP-A- 2003 100 657
- JP-A- 2005 340 685
- JP-A- 2005 340 685
- JP-A- 2006 351 743
- JP-A- 2007 165 657
- JP-A- 2007 243 080
- JP-A- 2008 135 653
- JP-A- 2010 040 564
- US-A- 5 744 826
- US-A1- 2007 057 262
- S. TAKENAMI ET AL: "Sloped Sidewalls in 4H-SiC Mesa Structure Formed by a Cl<sub>2</sub>-O<sub>2</sub> Thermal Etching", MATERIALS SCIENCE FORUM, vol. 556-557, 2007, pages 733-736, XP055089875, DOI: 10.4028/www.scientific.net/MSF.556-557.733
- Hiroshi Yano ET AL: "SiO 2 /SiC Interface Properties on Various Surface Orientations", Mat. Res. Soc. Symp. Proc., 1 January 2003 (2003-01-01), XP055142491, Retrieved from the Internet: URL:http://journals.cambridge.org/download .php?file=/OPL/OPL742/S1946427400151772a.p df&code=6867a49aee007409d563057d88374391 [retrieved on 2014-09-24]

## Description

### TECHNICAL FIELD

The present invention relates to a method for manufacturing a semiconductor device, more particularly, a semiconductor device utilizing an inclined surface formed in a silicon carbide layer and including a predetermined crystal plane.

### BACKGROUND ART

Conventionally, it has been proposed to use silicon carbide (SiC) as a material for a semiconductor device. For example. Patent Literature 1 (Japanese Patent Laying-Open No. 2002-261041) proposes to configure a device to have a high channel mobility by forming a channel on a {03-38} plane.

Further, Patent Literature 2 (Japanese Patent Laying-Open No. 2007-80971) proposes a semiconductor device employing silicon carbide. In the semiconductor device, a SiC semiconductor layer has a main surface having an orientation of substantially a {0001} plane and having an off angle α. A trench is formed in the SiC semiconductor layer such that the normal line of each of side wall surfaces of the trench to the main surface of the SiC semiconductor layer substantially corresponds to the <1 - 100> direction. The side wall surface of the trench forms an angle of not less than 60° and not more than "90° - tan⁻¹ (0.87 × tanα)" relative to the main surface of the SiC semiconductor layer. In Patent Literature 2, it is assumed difficult to maintain the angle of the side wall surface of the trench uniformly. Hence, with a premise that the plane orientation of the side wall varies to some extent, Patent Literature 2 provides restraint of change in channel mobility at the side wall by defining, to a predetermined direction, the direction in which the plane orientation of the side wall of the trench varies.

### CITATION LIST

### PATENT LITERATURE

PTL 1: Japanese Patent Laying-Open No. 2002-261041
PTL 2: Japanese Patent Laying-Open No. 2007-80971

### SUMMARY OF INVENTION

### TECHNICAL PROBLEM

However, with the premise that the plane orientation of the side wall varies as described above, the channel mobility is significantly decreased when the plane orientation of the side wall is deviated by not less than 1° relative to the {03-3-8} plane in the case where the {03-3-8} plane, which allows for a high channel mobility, is intended to be used for the side wall, disadvantageously. This is due to the following reason. That is, when the plane orientation of the side wall is deviated by 1° relative to the {03-3-8} plane, a multiplicity of steps (level difference) are formed in the side wall surface. Accordingly, electrons traveling in the side wall surface are dispersed by the steps, with the result that the channel mobility is decreased. Accordingly, the characteristics of the semiconductor device produced finally may be deteriorated.

The present invention has been made in view of the foregoing problem, and has its object to provide a high-quality semiconductor device having stable characteristics and a method for manufacturing such a semiconductor device.

JP2005340685 discloses trench gated vertical MOSFET and IGBT devices based on hexagonal crystal type SiC and in which the channel region is formed along the side walls of the trenches. In one of the examples disclosed in that document, linear trenches are etched using tapered masks so that their side walls lie on a {03-3-8} plane.

In S. TAKENAMI ET AL: "Sloped Sidewalls in 4H-SiC Mesa Structure Formed by a Cl2-O2 Thermal Etching", MATERIALS SCIENCE FORUM, vol. 556-557, January 2007, pages 733-736, a method of forming trenches in 4H-SiC by thermal etching is disclosed. The resulting side walls are aligned substantially along the {03-3-8} plane.

### SOLUTION TO PROBLEM

As a result of diligent study, the inventors have found that by processing a silicon carbide single-crystal under predetermined conditions, a surface corresponding to a {03-3-8} plane (so-called "semi-polar plane") can be formed as a spontaneously formed surface. It has been found that when the surface thus spontaneously formed and corresponding to the {03-3-8} plane is used as an active region (for example channel region) of the semiconductor device, a semiconductor device excellent in electric characteristics (for example, large in channel mobility) can be realized.

It should be noted that the expression "the end surface substantially includes the {03-3-8} plane" refers to a case where the crystal plane constituting the end surface is the {03-3-8} plane, and a case where the crystal plane constituting the end surface portion is a plane having an off angle of not less than -3° and not more than 3° relative to the {03-3-8} plane in the <1-100> direction. It should be also noted that the "off angle relative to the {03-3-8} plane in the <1-100> direction" refers to an angle formed by an orthogonal projection of a normal line of the above-described end surface to a flat plane defined by the <1-100> direction and the <0001> direction, and a normal line of the {03-3-8} plane. The sign of positive value corresponds to a case where the orthogonal projection approaches in parallel with the <1-100> direction whereas the sign of negative value corresponds to a case where the orthogonal projection approaches in parallel with the <0001> direction.

In this way, the end surface of the silicon carbide layer substantially corresponds to the {03-3-8} plane. Hence, the end surface corresponding to the so-called "semi-polar plane" can be used as a channel region (active region) of the semiconductor device. Further, the end surface corresponds to the stable crystal plane and therefore achieves a high channel mobility. Accordingly, in the case where the end surface is employed for the channel region, there can be provided a high-quality semiconductor device exhibiting a higher channel mobility than that in the case of employing other crystal plane (for example, a (0001) plane) for the channel region. Further, the end surface thus substantially including the {03-3-8} plane can suppress a problem of decreasing the channel mobility due to existence of a multiplicity of steps (level difference) in the end surface as in the case where the crystal orientation of the end surface is deviated relative to the {03-3-8} plane.

Because the end surface substantially includes the stable {03-3-8} plane, the end surface hardly becomes rough even when the end surface is exposed to heat treatment atmosphere in heat treatment such as activation annealing performed after implantation of a conductive impurity. Accordingly, a step of forming a cap layer for protecting the end surface during the heat treatment can be omitted.

A method for manufacturing a semiconductor device according to the present invention is defined in claim 1.

### ADVANTAGEOUS EFFECTS OF INVENTION

According to the present invention, there can be obtained a high-quality semiconductor device having stable characteristics.

### BRIEF DESCRIPTION OF DRAWINGS

Fig. 1 is a schematic planar view showing a first embodiment of a semiconductor device a which can be manufactured according to the present invention. The embodiment of fig. 1, however, does not form part of the claimed invention.
Fig. 2 is a schematic cross sectional view taken along a line segment II-II in Fig. 1.
Fig. 3 is a schematic cross sectional view for illustrating a method for manufacturing the semiconductor device shown in Fig. 1 and Fig. 2.
Fig. 4 is a schematic cross sectional view for illustrating the method for manufacturing the semiconductor device shown in Fig. 1 and Fig. 2.
Fig. 5 is a schematic cross sectional view for illustrating the method for manufacturing the semiconductor device shown in Fig. 1 and Fig. 2.
Fig. 6 is a schematic cross sectional view for illustrating the method for manufacturing the semiconductor device shown in Fig. 1 and Fig. 2.
Fig. 7 is a schematic cross sectional view for illustrating the method for manufacturing the semiconductor device shown in Fig. 1 and Fig. 2.
Fig. 8 is a schematic perspective view for illustrating the method for manufacturing the semiconductor device shown in Fig. 1 and Fig. 2.
Fig. 9 is a schematic cross sectional view for illustrating the method for manufacturing the semiconductor device shown in Fig. 1 and Fig. 2.
Fig. 10 is a schematic cross sectional view for illustrating the method for manufacturing the semiconductor device shown in Fig. 1 and Fig. 2.
Fig. 11 is a schematic cross sectional view for illustrating the method for manufacturing the semiconductor device shown in Fig. 1 and Fig. 2.
Fig. 12 is a schematic cross sectional view for illustrating a non claimed variation of the method for manufacturing the semiconductor device shown in Fig. 1 and Fig. 2.
Fig. 13 is a schematic cross sectional view for illustrating the non claimed variation of the method for manufacturing the semiconductor device shown in Fig. 1 and Fig. 2.
Fig. 14 is a schematic cross sectional view showing a non claimed variation of the semiconductor device shown in Fig. 1 and Fig. 2.
Fig. 15 is a schematic cross sectional view showing a second embodiment of the semiconductor a device which can be manufactured according according to the present invention. The embodiment of fig. 15, however, does not form part of the claimed invention.
Fig. 16 is a schematic cross sectional view for illustrating a method for manufacturing the semiconductor device shown in Fig. 15.
Fig. 17 is a schematic cross sectional view for illustrating the method for manufacturing the semiconductor device shown in Fig. 15.
Fig. 18 is a schematic cross sectional view for illustrating the method for manufacturing the semiconductor device shown in Fig. 15.
Fig. 19 is a schematic cross sectional view for illustrating the method for manufacturing the semiconductor device shown in Fig. 15.
Fig. 20 is a schematic cross sectional view for illustrating the method for manufacturing the semiconductor device shown in Fig. 15.
Fig. 21 is a schematic cross sectional view for illustrating the method for manufacturing the semiconductor device shown in Fig. 15.
Fig. 22 is a schematic cross sectional view for illustrating the method for manufacturing the semiconductor device shown in Fig. 15.
Fig. 23 is a schematic cross sectional view for illustrating the method for manufacturing the semiconductor device shown in Fig. 15.
Fig. 24 is a schematic cross sectional view showing a non claimed variation of the semiconductor device shown in Fig. 15.
Fig. 25 is a schematic cross sectional view showing a reference example not forming part of the claimed invention.
Fig. 26 is a schematic cross sectional view showing a variation of the semiconductor device shown in Fig. 25.
Fig. 27 is an enlarged partial schematic cross sectional view of the side surface of the silicon carbide layer.

### DESCRIPTION OF EMBODIMENTS

The following describes embodiments of the present invention as well embodiments not forming part of the present invention with reference to figures. It should be noted that in the below-mentioned figures, the same or corresponding portions are given the same reference characters and are not described repeatedly. Further, in the present specification, an individual orientation is represented by [], a group orientation is represented by <>, and an individual plane is represented by (), and a group plane is represented by {}. In addition, a negative index is supposed to be crystallographically indicated by putting "-" (bar) above a numeral, but is indicated by putting the negative sign before the numeral in the present specification.

### (First Embodiment)

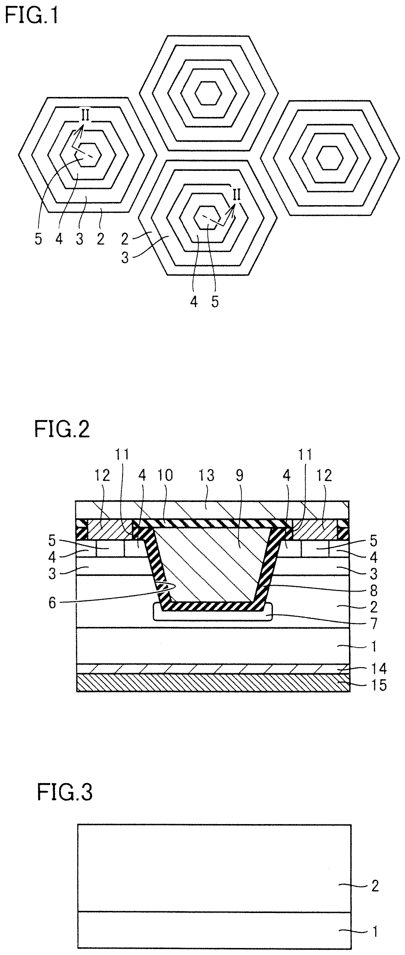

Referring to Fig. 1 and Fig. 2, a first embodiment of a semiconductor device which can be manufactured according to the method of the present invention will be described.

Referring to Fig. 1 and Fig. 2, the semiconductor device is a vertical type MOSFET. which is a vertical type device employing a plurality of mesa structures and a trench formed between the mesa structures and having an inclined side surface. The semiconductor device shown in Fig. 1 and Fig. 2 includes: a substrate 1 made of silicon carbide: a breakdown voltage holding layer 2 made of silicon carbide and serving as an epitaxial layer having n type conductivity; p type body layers 3 (p type semiconductor layers 3) made of silicon carbide and having p type conductivity; n type source contact layers 4 made of silicon carbide and having n type conductivity; contact regions 5 made of silicon carbide and having p type conductivity; a gate insulating film 8; a gate electrode 9; an interlayer insulating film 10; source electrodes 12; a source wire electrode 13; a drain electrode 14: and a backside surface protecting electrode 15.

As shown in Fig. 1, the plurality of (four in Fig. 1) mesa structures are formed by partially removing the silicon carbide layers on the main surface of substrate 1. Specifically, each of the mesa structures has an upper surface and a bottom surface each having a hexagon shape, and has a side wall inclined relative to the main surface of substrate 1. Between adjacent mesa structures, a trench 6 is formed to have inclined side surfaces 20 constituted by the side walls of the mesa structures.

Further, in the semiconductor device shown in Fig. 1 and Fig. 2, substrate 1 is made of silicon carbide of a hexagonal crystal type. Breakdown voltage holding layer 2 is formed on one main surface of substrate 1. Each of p type body layers 3 is formed on breakdown voltage holding layer 2. On p type body layer 3, n type source contact layer 4 is formed. P type contact region 5 is formed to be surrounded by n type source contact layer 4. By removing portions of n type source contact layer 4, p type body layer 3. and breakdown voltage holding layer 2. the mesa structures surrounded by trench 6 are formed. Each of the side walls of trench 6 (each of the side walls of the mesa structures) serves as an end surface inclined relative to the main surface of substrate 1 . The inclined end surface surrounds a projection portion (projection-shaped portion serving as each of the mesa structures and having an upper surface on which source electrode 12 is formed). The projection portion has a hexagonal planar shape as shown in Fig. 1.

Gate insulating film 8 is formed on the side walls and bottom wall of trench 6. Gate insulating film 8 extends onto the upper surface of each of n type source contact layers 4. Gate electrode 9 is formed on gate insulating film 8 to fill the inside of trench 6 (i.e., fill the space between adjacent mesa structures). Gate electrode 9 has an upper surface substantially as high as the upper surface of a portion of gate insulating film 8 on the upper surface of each of n type source contact layers 4.

Interlayer insulating film 10 is formed to cover gate electrode 9 as well as the portion of gate insulating film 8 on the upper surface of each of n type source contact layers 4. By removing portions of interlayer insulating film 10 and gate insulating film 8, openings 11 are formed to expose portions of n type source contact layers 4 and p type contact regions 5. Source electrodes 12 are formed in contact with p type contact regions 5 and the portions of n type source contact layers 4 so as to fill the inside of openings 11. Source wire electrode 13 is formed in contact with the upper surface of each of source electrodes 12 so as to extend on the upper surface of interlayer insulating film 10. Further, drain electrode 14 is formed on the backside surface of substrate 1 opposite to its main surface on which breakdown voltage holding layer 2 is formed. This drain electrode 14 is an ohmic electrode. Drain electrode 14 has a surface which is opposite to its surface facing substrate 1 and on which a backside surface protecting electrode 15 is formed.

In the semiconductor device shown in Fig. 1 and Fig. 2, each of the side walls of trench 6 (each of the side walls of the mesa structures) is inclined and substantially corresponds to the {03-3-8} plane in the case where the silicon carbide constituting breakdown voltage holding layer 2 and the like is of hexagonal crystal type.

Specifically, the crystal plane constituting the side wall is a plane having an off angle of not less than -3° and not more than 3°, more preferably, not less than -1° and not more than 1° relative to the {03-3-8} plane in the <1-100> direction. As seen from Fig. 2, each of the side walls thus corresponding to the so-called "semi-polar plane" can be used as a channel region, which is an active region of the semiconductor device. Because each of the side walls corresponds to the stable crystal plane, a higher channel mobility can be obtained in the case where such a side wall is employed for the channel region, as compared with a case where another crystal plane (such as the (0001) plane) is employed for the channel region. In addition, leakage current can be reduced sufficiently and high breakdown voltage can be obtained.

The following briefly describes operations of the semiconductor device shown in Fig. 1 and Fig. 2. Referring to Fig. 2, when a voltage equal to or smaller than the threshold value is applied to gate electrode 9, i.e., when the semiconductor device is in an OFF state, p type body layer 3 and breakdown voltage holding layer 2 of n type conductivity are reverse-biased. Hence, it is in a non-conductive state. On the other hand, when gate electrode 9 is fed with a positive voltage, an inversion layer is formed in the channel region near a region of p type body layer 3 in contact with gate insulating film 8. Accordingly, n type source contact layer 4 and breakdown voltage holding layer 2 are electrically connected to each other. As a result, a current flows between source electrode 12 and drain electrode 14.

The following describes a method according to a first embodiment of the invention for manufacturing the semiconductor device shown in Fig. 1 and Fig. 2, with reference to Fig. 3 to Fig. 11.

First, referring to Fig. 3, on the main surface of substrate 1 made of silicon carbide, an epitaxial layer of silicon carbide with n type conductivity is formed. The epitaxial layer serves as breakdown voltage holding layer 2. Breakdown voltage holding layer 2 is formed by means of epitaxial growth employing a CVD method that utilizes a mixed gas of silane (SiH₄) and propane (C₃H₈) as a material gas and utilizes hydrogen gas (H₂) as a carrier gas, for example. In doing so, it is preferable to introduce nitrogen (N) or phosphorus (P) as an impurity of n type conductivity, for example. Breakdown voltage holding layer 2 can contain the n type impurity at a concentration of, for example, not less than 5 × 10¹⁵cm⁻³and not more than 5 × 10¹⁶ cm⁻3

Next, ions are implanted into the upper surface layer of breakdown voltage holding layer 2, thereby forming p type body layer 3 and n type source contact layer 4. In the ion implantation for forming p type body layer 3, ions of an impurity of p type conductivity such as aluminum (Al) are implanted. In doing so, by adjusting acceleration energy of the ions to be implanted, the depth of the region in which p type body layer 3 is to be formed can be adjusted.

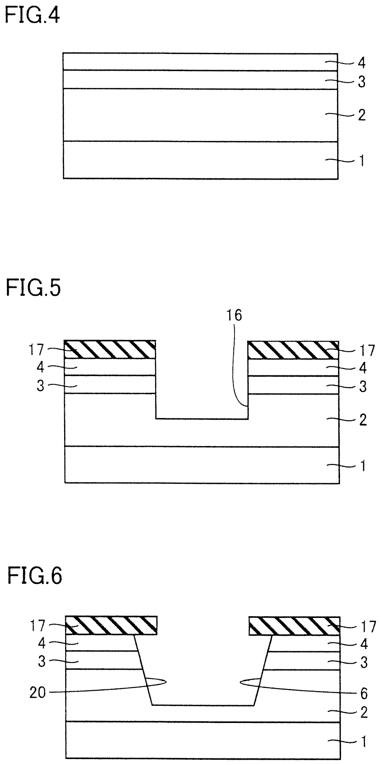

Next, ions of an impurity of n type conductivity are implanted into breakdown voltage holding layer 2 thus having p type body layer 3 formed therein, thereby forming n type source contact layer 4. An exemplary, usable n type impurity is phosphorus or the like. In this way, a structure shown in Fig. 4 is obtained.

Next, as shown in Fig. 5, a mask layer 17 is formed on the upper surface of n type source contact layer 4. As mask layer 17, an insulating film such as a silicon oxide film can be used. As a method for forming mask layer 17, the following process can be employed, for example. That is, a silicon oxide film is formed on the upper surface of n type source contact layer 4 by means of the CVD method or the like. Then, a resist film (not shown) having a predetermined opening pattern is formed on the silicon oxide film by means of the photolithography method. Using the resist film as a mask, a portion of the silicon oxide film is removed by etching. Thereafter, the resist film is removed. As a result, mask layers 17 are formed which have an opening pattern in conformity with a region where trench 16 shown in Fig. 5 is to be formed.

Then, using mask layers 17 as a mask, portions of n type source contact layer 4, p type body layer 3, and breakdown voltage holding layer 2 are removed by means of reactive ion etching (RIE), in particular, inductively coupled plasma (ICP) RIE. Specifically, for example, ICP-RIE can be used which employs SF₆ or a mixed gas of SF₆ and O₂ as the reaction gas. By means of such etching, a trench 16 having a side wall substantially perpendicular to the main surface of substrate 1 is formed in the region where trench 6 shown in Fig. 2 is to be formed. In this way, a structure shown in Fig. 5 is obtained.

Next, a thermal etching step is performed to exhibit a predetermined crystal plane in each of breakdown voltage holding layer 2, p type body layer 3, and n type source contact layer 4. Specifically, each of the side walls of trench 16 shown in Fig. 5 is etched (thermally etched) at a heat treatment temperature of not less than 700°C and not more than 1000°C using a mixed gas of oxygen gas and chlorine gas as the reaction gas, thereby forming trench 6 having side surfaces 20 inclined relative to the main surface of substrate 1 as shown in Fig. 6, for example.

Here, main reaction proceeds in the thermal etching step under conditions that 0.5 ≤ x ≤ 2.0 and 1.0 ≤ y ≤ 2.0 are satisfied in the following reaction formula: SiC + mO₂ + nCl₂ → SiClₓ + CO_{y} (where m, n, x, y are positive numbers). Under conditions that x = 4 and y = 2, the reaction (thermal etching) proceeds the best. It should be noted that the reaction gas may contain a carrier gas in addition to the chlorine gas and the oxygen gas. An exemplary, usable carrier gas is nitrogen (N₂) gas, argon gas, helium gas, or the like. When the heat treatment temperature is set at not less than 700°C and not more than 1000°C, a rate of etching SiC is approximately, for example, 70 µm/hr. Further, when using silicon oxide (SiO₂) as each of mask layers 17 in this case, a selection ratio of SiC to SiO₂ can be very large. Accordingly, mask layer 17 made of SiO₂ is not substantially etched during etching of SiC.

It should be noted that the crystal plane exhibited at each of side surfaces 20 substantially corresponds to the {03-3-8} plane. Namely, in the etching under the above-described conditions, side surface 20 of trench 6 is spontaneously formed to correspond to the {03-3-8} plane, which is a crystal plane allowing for the slowest etching rate. As a result, a structure shown in Fig. 6 is obtained. It should be noted that, in embodiments not forming part of the claimed invention, the crystal plane constituting side surface 20 may be the {01-1-4} plane. Further, in the case where the crystal type of silicon carbide constituting breakdown voltage holding layer 2 or the like is cubic crystal, which does not form part of the claimed invention, the crystal plane constituting side surface 20 may correspond to the {100} plane.

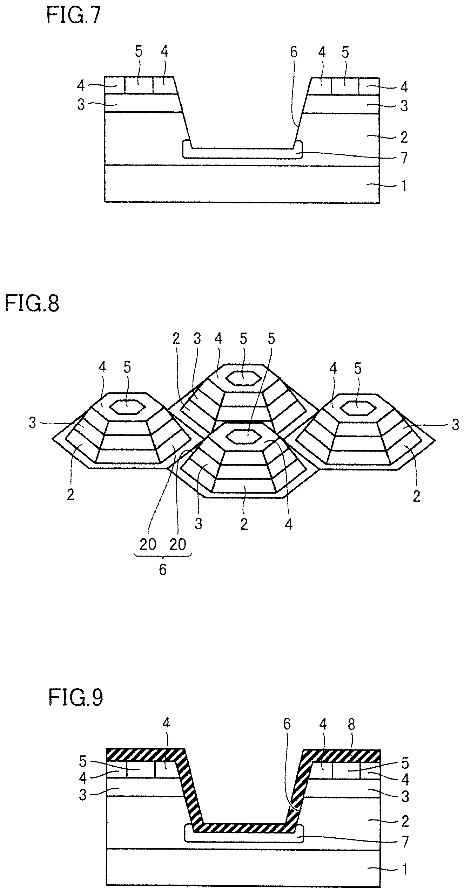

Next, mask layers 17 are removed by any method such as etching. Thereafter, a resist film (not shown) having a predetermined pattern is formed using a photolithography method so as to extend from the inside of trench 6 onto each of the upper surfaces of n type source contact layers 4. As the resist film, there can be used a resist film having an opening pattern in conformity with the bottom portion of trench 6 and a portion of the upper surface of n type source contact layer 4. By implanting ions of an impurity of p type conductivity using this resist film as a mask, an electric field relaxing region 7 is formed at the bottom portion of trench 6 and contact region 5 of p type conductivity is formed at the region of the portion of n type source contact layer 4. Thereafter, the resist film is removed. As a result, a structure shown in Fig. 7 and Fig. 8 is obtained. As seen from Fig. 8, trench 6 has a planar shape in the form of a mesh constituted by unit cells (each defined by annular portion of trench 6 surrounding one mesa structure) each having a hexagonal planar shape. Further, p type contact region 5 is disposed substantially at the central portion of the upper surface of each of the mesa structures as shown in Fig. 8. Further, p type contact region 5 has a planar shape similar to the shape of circumference of the upper surface of the mesa structure, i.e., has a hexagonal planar shape.

Then, an activation annealing step is performed to activate the impurity implanted by means of the above-described ion implantation. In this activation annealing step, the annealing treatment is performed without forming any particular cap layer on the surface of the epitaxial layer made of silicon carbide (for example, on the side wall of the mesa structure). Here, the inventors have found that even when the activation annealing treatment is performed without forming a protective film such as the cap layer on the surface thereof in the case where the above-described {03-3-8} plane is employed, a property of the surface is never deteriorated and sufficient surface smoothness can be maintained. Thus, the conventionally required step of forming the protective film (cap layer) before the activation annealing treatment is omitted and the activation annealing step is directly performed. It should be noted that the above-described cap layer may be formed before performing the activation annealing step. Alternatively, for example, the cap layer may be provided only on the upper surfaces of n type source contact layer 4 and p type contact region 5 before performing the activation annealing treatment.

Next, as shown in Fig. 9, gate insulating film 8 is formed to extend from the inside of trench 6 onto the upper surfaces of n type source contact layer 4 and p type contact region 5. As gate insulating film 8, for example, there can be used an oxide film (silicon oxide film) obtained by thermally oxidizing the epitaxial layer made of silicon carbide. In this way, a structure shown in Fig. 9 is obtained.

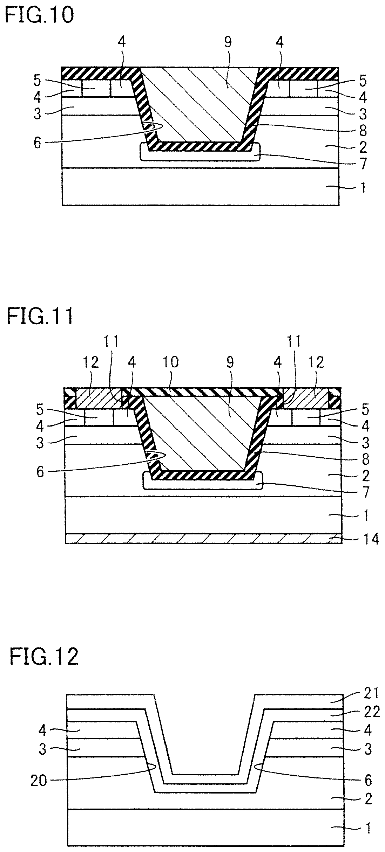

Next, as shown in Fig. 10, gate electrode 9 is formed on gate insulating film 8 so as to fill the inside of trench 6. As a method for forming gate electrode 9, the following method can be used, for example. First, a sputtering method is employed to form a conductor film on gate insulating film 8. The conductor film is to be the gate electrode extending to the inside of trench 6 and to a region on p type contact region 5. The conductor film may be made of any material such as a metal as long as the material has conductivity. Thereafter, an appropriate method such as an etch back method or a CMP method is used to remove a portion of the conductor film formed on regions other than the inside of trench 6. As a result, the conductor film filling the inside of trench 6 remains to constitute gate electrode 9. In this way, a structure shown in Fig. 10 is obtained.

Next, interlayer insulating film 10 (see Fig. 11) is formed to cover the upper surface of gate electrode 9 and the upper surface of gate insulating film 8 exposed on p type contact region 5. The interlayer insulating film can be made of any material as long as the material is insulative. Further, a resist film having a pattern is formed on interlayer insulating film 10, using the photolithography method. The resist film (not shown) is provided with an opening pattern formed in conformity with a region on p type contact region 5.

Using this resist film as a mask, portions of interlayer insulating film 10 and gate insulating film 8 are removed by means of etching. As a result, openings 11 (see Fig. 11) are formed to extend through interlayer insulating film 10 and gate insulating film 8. Each of openings 11 has a bottom portion at which p type contact region 5 and a portion of n type source contact layer 4 are exposed. Thereafter, a conductor film to serve as source electrode 12 (see Fig. 11) is formed to fill the inside of opening 11 and cover the upper surface of the above-described resist film. Thereafter, the resist film is removed using a chemical solution or the like, thereby simultaneously removing the portion of the conductor film formed on the resist film (lift off). As a result, the conductor film filling the inside of opening 11 constitutes source electrode 12. This source electrode 12 is an ohmic electrode making ohmic contact with p type contact region 5 and n type source contact layer 4.

Further, drain electrode 14 (see Fig. 11) is formed on the backside surface of substrate 1 (the surface thereof opposite to the main surface thereof on which breakdown voltage holding layer 2 is formed). Drain electrode 14 can be made of any material as long as the material allows for ohmic contact with substrate 1. In this way, a structure shown in Fig. 11 is obtained.

Thereafter, an appropriate method such as the sputtering method is employed to form source wire electrode 13 (see Fig. 2) and backside surface protecting electrode 15 (see Fig. 2). Source wire electrode 13 makes contact with each of the upper surfaces of source electrodes 12, and extends on the upper surface of interlayer insulating film 10. Backside surface protecting electrode 15 is formed on the surface of drain electrode 14. As a result, the semiconductor device shown in Fig. 1 and Fig. 2 can be obtained.

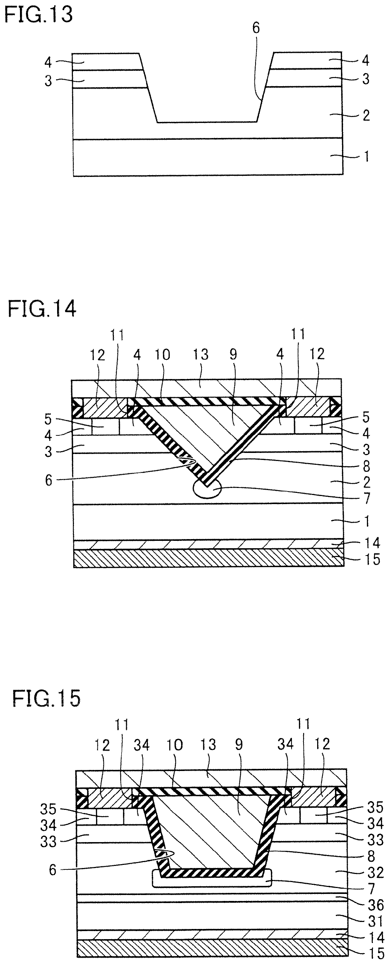

Referring to Fig. 12 and Fig. 13, the following describes a variation of the method for manufacturing the semiconductor device shown in Fig. 1 and Fig. 2. This variation does not form part of the claimed invention.

In the variation of the method, the steps shown in Fig. 3 to Fig. 5 are performed first. Thereafter, mask layers 17 shown in Fig. 5 are removed. Next, a Si film 21 (see Fig. 12) made of silicon is formed to extend from the inside of trench 16 to the upper surface of n type source contact layer 4. In this state, heat treatment is performed to cause reconstitution of silicon carbide at a region in contact with Si film 21 on the inner circumferential surface of trench 16 and the upper surface of n type source contact layer 4. Accordingly, a reconstitution layer 22 of silicon carbide is formed as shown in Fig. 12 such that each of the side walls of the trench corresponds to a predetermined crystal plane ({03-3-8} plane). In this way. a structure shown in Fig. 12 is obtained.

Thereafter, remaining Si film 21 is removed. Si film 21 can be removed by means of, for example, etching that uses a mixed gas of HNO₃ and HF or the like. Thereafter, the surface layer of reconstitution layer 22 described above is removed by means of etching. As etching for removing reconstitution layer 22. ICP-RIE can be used. As a result, trench 6 having its inclined side surface as shown in Fig. 13 can be formed.

Thereafter, by performing the above-described steps shown in Fig. 7 to Fig. 11, the semiconductor device shown in Fig. 1 and Fig. 2 can be obtained.

Next, referring to Fig. 14, a variation of the semiconductor device shown in Fig. 1 and Fig. 2 is described. A semiconductor device shown in Fig. 14 basically has the same configuration as that of the semiconductor device shown in Fig. 1 and Fig. 2, but is different therefrom in terms of the shape of trench 6. Specifically, in the semiconductor device shown in Fig. 14, trench 6 has a V-shaped cross sectional shape. Further, from a different point of view, trench 6 of the semiconductor device shown in Fig. 14 has side surfaces inclined relative to the main surface of substrate 1, opposite to each other, and connected to each other at their lower portions. At the bottom portion of trench 6 (the portion at which the lower portions of the opposite side walls are connected to each other), an electric field relaxing region 7 is formed. With the semiconductor device thus configured, there can be provided the same effect as that of the semiconductor device shown in Fig. 1 and Fig. 2. Further, in the semiconductor device shown in Fig. 14, trench 6 does not have the flat bottom surface shown in Fig. 2. Accordingly, trench 6 shown in Fig. 14 has a width narrower than that of trench 6 shown in Fig. 2. As a result, the semiconductor device shown in Fig. 14 can be reduced in size as compared with the semiconductor device shown in Fig. 2. This is advantageous in attaining finer design and higher integration of the semiconductor device.

### (Second Embodiment)

Referring to Fig. 15, the following describes a second embodiment of the semiconductor device which can be manufactured according to a method of the present invention.

Referring to Fig. 15, the semiconductor device is an IGBT, which is a vertical type device utilizing a trench having an inclined side surface. The semiconductor device shown in Fig. 15 includes: a substrate 31 made of silicon carbide and having p type conductivity; a p type epitaxial layer 36 made of silicon carbide and serving as a buffer layer having p type conductivity; an n type epitaxial layer 32 made of silicon carbide and serving as a breakdown voltage holding layer having n type conductivity; p type semiconductor layers 33 made of silicon carbide and corresponding to a well region having p type conductivity; n type source contact layers 34 made of silicon carbide and corresponding to an emitter region having n type conductivity; contact regions 35 made of silicon carbide and having p type conductivity; a gate insulating film 8; a gate electrode 9; an interlayer insulating film 10; a source electrode 12 corresponding to an emitter electrode; a source wire electrode 13; a drain electrode 14 corresponding to a collector electrode; and a backside surface protecting electrode 15.

P type epitaxial layer 36 serving as the buffer layer is formed on one main surface of substrate 31. On p type epitaxial layer 36, n type epitaxial layer 32 is formed. On n type epitaxial layer 32, each of p type semiconductor layers 33 is formed. On p type semiconductor layer 33, n type source contact layer 34 is formed. P type contact region 35 is formed and surrounded by n type source contact layer 34. By removing portions of n type source contact layer 34, p type semiconductor layer 33, and n type epitaxial layer 32, a trench 6 is formed. Each of the side walls of trench 6 serves an end surface inclined relative to the main surface of substrate 31. The inclined end surface surrounds a projection portion (mesa structure in the form of a projection-shaped portion having an upper surface on which source electrode 12 is formed). The projection portion has a hexagonal planar shape as with that of the semiconductor device shown in Fig. 1 or the like.

Gate insulating film 8 is formed on the side walls and bottom wall of trench 6. Gate insulating film 8 extends onto the upper surface of n type source contact layer 34. On this gate insulating film 8, gate electrode 9 is formed to fill the inside of trench 6. Gate electrode 9 has an upper surface substantially as high as the upper surface of a portion of gate insulating film 8 on the upper surface of n type source contact layer 34.

Interlayer insulating film 10 is formed to cover gate electrode 9 as well as the portion of gate insulating film 8 on the upper surface of n type source contact layer 34. By removing portions of interlayer insulating film 10 and gate insulating film 8, openings 11 are formed to expose portions of n type source contact layers 34 and p type contact regions 35. Source electrodes 12 are formed in contact with p type contact regions 35 and the portions of n type source contact layers 34 so as to fill the inside of openings 11. Source wire electrode 13 is formed in contact with the upper surface of source electrode 12 so as to extend on the upper surface of interlayer insulating film 10.

Further, as with the semiconductor device shown in Fig. 1 and Fig. 2, drain electrode 14 and backside surface protecting electrode 15 are formed on the backside surface of substrate 31 opposite to its main surface on which breakdown voltage holding layer 2 is formed.

As with the semiconductor device shown in Fig. 1 and Fig. 2, in the semiconductor device shown in Fig. 15, each of the side walls of trench 6 is inclined and substantially corresponds to the {03-3-8} plane in the case where the silicon carbide constituting n type epitaxial layer 32 and the like is of hexagonal crystal type. Also in this case, an effect similar to that of the semiconductor device shown in Fig. 1 can be obtained. It should be noted that the side wall in the semiconductor device of embodiments not forming part of the claimed invention may substantially correspond to the {01-1-4} plane. Further, in the case where the crystal type of silicon carbide constituting n type epitaxial layer 32 or the like is cubic crystal, which does not form part of the claimed invention, the inclined side wall of trench 6 may correspond to substantially the {100} plane.

The following briefly describes operations of the semiconductor device shown in Fig. 15. Referring to Fig. 15, when a negative voltage is applied to gate electrode 9 and exceeds a threshold value, an inversion layer is formed at an end region (channel region) of p type semiconductor layer 33 that is in contact with gate insulating film 8 disposed lateral to gate electrode 9 and that faces trench 6. Accordingly, n type source contact layer 34 serving as the emitter region and n type epitaxial layer 32 serving as the breakdown voltage holding layer are electrically connected to each other. Accordingly, positive holes are injected from n type source contact layer 34 serving as the emitter region to n type epitaxial layer 32 serving as the breakdown voltage holding layer. Correspondingly, electrons are supplied from substrate 3 1 to n type epitaxial layer 32 via p type epitaxial layer 36 serving as the buffer layer. As a result, the IGBT is brought into the ON state. Accordingly, conductivity modulation takes place in n type epitaxial layer 32 to decrease a resistance between source electrode 12 serving as the emitter electrode and drain electrode 14 serving as the collector electrode, thus allowing a current to flow therein. On the other hand, when the negative voltage applied to gate electrode 9 is equal to or smaller than the threshold value, the inversion layer is not formed in the channel region. Hence, the reverse-biased state is maintained between n type epitaxial layer 32 and p type semiconductor layer 33. As a result, the IGBT is brought into the OFF state, whereby no current flows therein.

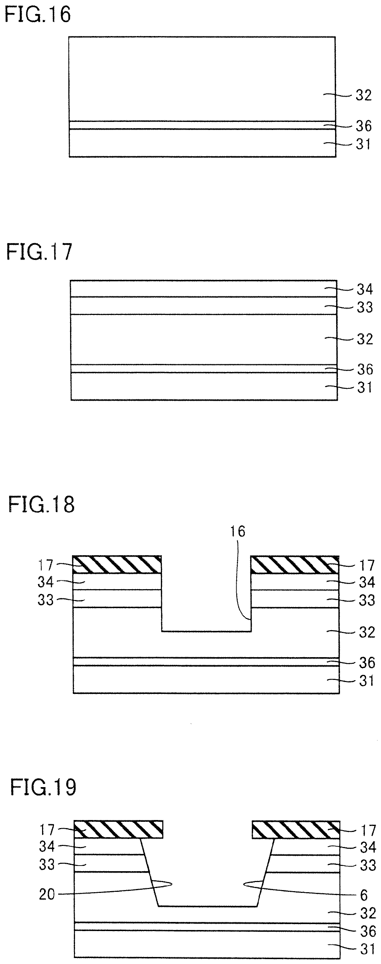

Referring to Fig. 16 to Fig. 23. the following describes a second embodiment of the inventive method for manufacturing the semiconductor device shown in fig. 15.

First, referring to Fig. 16, on the main surface of substrate 31 made of silicon carbide, p type epitaxial layer 36 made of silicon carbide having p type conductivity is formed. Further, on p type epitaxial layer 36, n type epitaxial layer 32 of silicon carbide of n type conductivity is formed. N type epitaxial layer 32 serves as breakdown voltage holding layer 32. P type epitaxial layer 36 and n type epitaxial layer 32 are formed by means of epitaxial growth employing the CVD method that utilizes a mixed gas of silane (SiH₄) and propane (C₃H₈) as a material gas, and utilizes a hydrogen gas (H₂) as a carrier gas, for example. In doing so, it is preferable to introduce, for example, aluminum (Al) as the impurity of p type conductivity, and to introduce, for example, nitrogen (N) or phosphorus (P) as the impurity of n type conductivity.

Next, ions are implanted into the upper surface layer of n type epitaxial layer 32. thereby forming p type semiconductor layer 33 and n type source contact layer 34. In the ion implantation for forming p type semiconductor layer 33, ions of an impurity of p type conductivity such as aluminum (Al) are implanted. In doing so, by adjusting acceleration energy of the ions to be implanted, the depth of the region in which p type semiconductor layer 33 is to be formed can be adjusted.

Next, ions of an impurity of n type conductivity are implanted into n type epitaxial layer 32 thus having p type semiconductor layer 33 formed thereon, thereby forming n type source contact layer 34. An exemplary, usable n type impurity is phosphorus or the like. In this way, a structure shown in Fig. 17 is obtained.

Next, as shown in Fig. 18, a mask layer 17 is formed on the upper surface of n type source contact layer 34. As mask layer 17, an insulating film such as a silicon oxide film can be used. As a method for forming mask layer 17. the same method as the method for manufacturing mask layer 17 as illustrated in Fig. 5 can be used. As a result, mask layers 17 are formed which have an opening pattern in conformity with a region where trench 16 shown in Fig. 18 is to be formed.

Then, using mask layers 17 as a mask, portions of n type source contact layer 34, p type semiconductor layer 33, and n type epitaxial layer 32 are removed by means of etching. As a method or the like for the etching, the same method can be used as that of the process illustrated in Fig. 5. In this way, a structure shown in Fig. 18 is obtained.

Next, a thermal etching step is performed to exhibit a predetermined crystal plane in each of n type epitaxial layer 32, p type semiconductor layer 33, and n type source contact layer 34. Conditions for this thermal etching step can be the same as the conditions for the thermal etching step described with reference to Fig. 6. As a result, trench 6 can be formed which has side surfaces 20 inclined relative to the main surface of substrate 31 as shown in Fig. 19. It should be noted that the plane orientation of the crystal plane exhibited at each of side surfaces 20 is {03-3-8}. In this way, a structure shown in Fig. 19 is obtained.

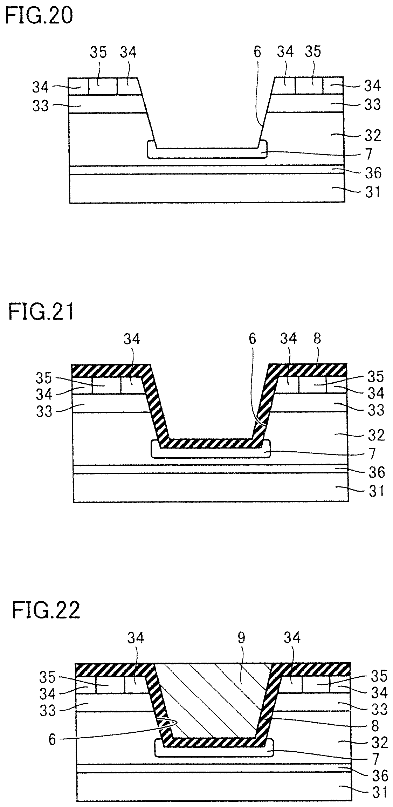

Next, each of mask layers 17 is removed by means of an appropriate method such as etching. Thereafter, as with the step shown in Fig. 7, a resist film (not shown) having a predetermined pattern is formed using the photolithography method to extend from the inside of trench 6 onto the upper surface of n type source contact layer 34. As the resist film, there can be used a resist film having an opening pattern in conformity with the bottom portion of trench 6 and a portion of the upper surface of n type source contact layer 34. By implanting ions of an impurity of p type conductivity using this resist film as a mask, an electric field relaxing region 7 is formed at the bottom portion of trench 6 and contact region 35 of p type conductivity is formed at the region of the portion of n type source contact layer 34. Thereafter, the resist film is removed. In this way, a structure shown in Fig. 20 is obtained.

Then, an activation annealing step is performed to activate the impurity implanted by means of the above-described ion implantation. In this activation annealing step, as with the case of the above-described first embodiment of the present invention, the annealing treatment is performed without forming a particular cap layer on the surface of the epitaxial layer made of silicon carbide (specifically, on side surface 20 of trench 6). It should be noted that the above-described cap layer may be formed before performing the activation annealing step. Alternatively, for example, the cap layer may be provided only on the upper surfaces of n type source contact layer 34 and p type contact region 35 before performing the activation annealing treatment.

Next, as shown in Fig. 21, gate insulating film 8 is formed to extend from the inside of trench 6 onto the upper surfaces of n type source contact layer 4 and p type contact region 5. Gate insulating film 8 is made of the same material as that of gate insulating film 8 shown in Fig. 9 and is formed by means of the same method as the method for forming gate insulating film 8 shown in Fig. 9. In this way, a structure shown in Fig. 21 is obtained.

Next, as shown in Fig. 22, gate electrode 9 is formed on gate insulating film 8 to fill the inside of trench 6. Gate electrode 9 can be formed by means of the same method as the method of forming gate electrode 9 shown in Fig. 10. In this way, a structure shown in Fig. 22 is obtained.

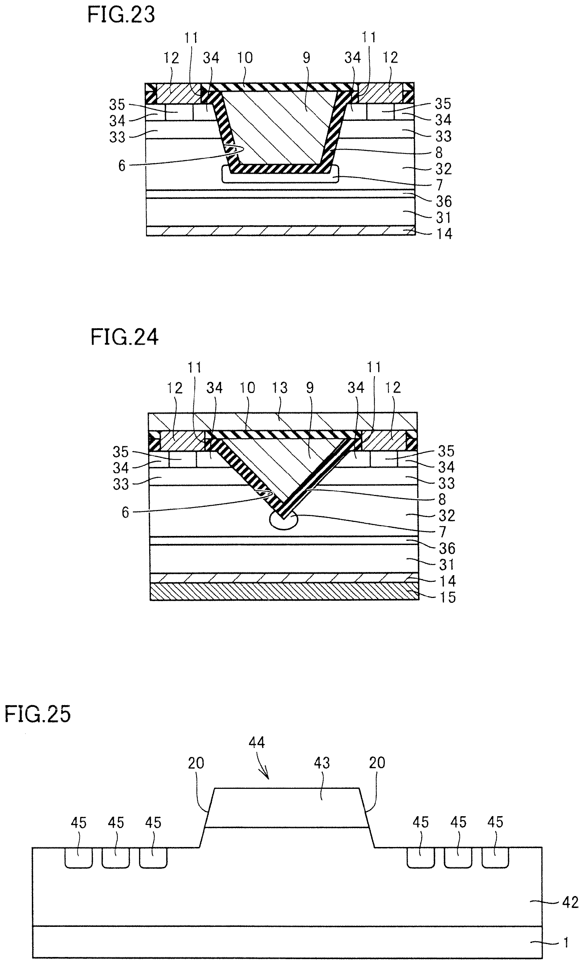

Next, interlayer insulating film 10 (see Fig. 23) is formed to cover the upper surface of gate electrode 9 and the upper surface of gate insulating film 8 exposed on p type contact region 35. Interlayer insulating film 10 can be made of any material as long as the material is insulative. Further, as with the step shown in Fig. 11, openings 11 (see Fig. 23) are formed in interlayer insulating film 10 and gate insulating film 8. Each of openings 11 is formed using the same method as the method of forming the opening in Fig. 11. Opening 11 has a bottom portion at which p type contact region 35 and a portion of n type source contact layer 34 are exposed.

Thereafter, using the same method as the method illustrated in Fig. 11, source electrode 12 is formed by a conductor film filling the inside of opening 11. This source electrode 12 is an ohmic electrode making ohmic contact with p type contact region 35 and n type source contact layer 34.

Further, drain electrode 14 (see Fig. 23) is formed on the backside surface of substrate 31 (the surface thereof opposite to the main surface thereof on which n type epitaxial layer 32 is formed). Drain electrode 14 can be made of any material as long as the material allows for ohmic contact with substrate 3 1. In this way, a structure shown in Fig. 23 is obtained.

Thereafter, an appropriate method such as the sputtering method is employed to form source wire electrode 13 (see Fig. 15) and backside surface protecting electrode 15 (see Fig. 15). Source wire electrode 13 makes contact with the upper surface of source electrode 12, and extends on the upper surface of interlayer insulating film 10. Backside surface protecting electrode 15 is formed on the surface of drain electrode 14. As a result, the semiconductor device shown in Fig. 15 can be obtained.

Next, referring to Fig. 24, a variation of the semiconductor device shown in Fig. 15 is described. A semiconductor device shown in Fig. 24 basically has the same configuration as that of the semiconductor device shown in Fig. 15, but is different therefrom in terms of in the shape of trench 6. Specifically, in the semiconductor device shown in Fig. 24, trench 6 has a V-shaped cross sectional shape as with that of the semiconductor device shown in Fig. 14. At the bottom portion of trench 6 (the portion at which the lower portions of the opposite side walls are connected to each other), an electric field relaxing region 7 is formed. With the semiconductor device thus configured, there can be provided the same effect as that of the semiconductor device shown in Fig. 15. Further, in the semiconductor device shown in Fig. 24, trench 6 does not have the flat bottom surface shown in Fig. 15. Accordingly, trench 6 shown in Fig. 24 has a width narrower than that of trench 6 shown in Fig. 15. As a result, the semiconductor device shown in Fig. 24 can be reduced in size as compared with the semiconductor device shown in Fig. 15. This is advantageous in attaining finer design and higher integration of the semiconductor device.

### (Reference Example)

Referring to Fig. 25, the following describes a reference example.

Referring to Fig. 25, the semiconductor device serving as the reference example of the present invention is a PiN diode, and includes: a substrate 1 made of silicon carbide; an n⁻ epitaxial layer 42 having n type conductivity, having a conductive impurity concentration lower than that in substrate 1, and having a ridge structure at its surface; a p⁺ semiconductor layer 43 formed in ridge structure 44 formed on the surface of n⁻ epitaxial layer 42 and connected to n⁻ epitaxial layer 42; and guard rings 45 formed to surround ridge structure 44. Substrate 1 is made of silicon carbide and has n type conductivity. N⁻ epitaxial layer 42 is formed on the main surface of substrate 1. N⁻epitaxial layer 42 has a surface that has ridge structure 44 formed thereon and having side surfaces 20 inclined relative to the main surface of substrate 1. In a layer including the upper surface of ridge structure 44, p⁺ semiconductor layer 43 having p type conductivity is formed. Guard rings 45, each of which is a region of p type conductivity, are formed to surround this ridge structure 44. Each of guard rings 45 is formed to have an annular shape to surround ridge structure 44. Each of side surfaces 20 of ridge structure 44 is constituted by a specific crystal plane (for example, a (03-3-8) plane). Namely, ridge structure 44 is constituted by six planes equivalent to the specific crystal plane ((03-3-8) plane). Accordingly, ridge structure 44 has its upper surface and bottom portion each having a hexagonal planar shape.

Also in the semiconductor device having such a structure, side surface 20 of ridge structure 44 corresponds to the stable crystal plane as with side surface 20 of trench 6 shown in Fig. 1. Hence, leakage current from side surface 20 can be sufficiently reduced as compared with that in the case where side surface 20 corresponds to the other crystal plane.

The following describes a method for manufacturing the semiconductor device shown in Fig. 25. In the method for manufacturing the semiconductor device shown in Fig. 25, substrate 1 made of silicon carbide is first prepared. As substrate 1, for example, there is used a substrate made of silicon carbide of hexagonal crystal type. N⁻ epitaxial layer 42 is formed on the main surface of substrate 1 using an epitaxy method. Into the surface layer of n⁻ epitaxial layer 42, ions of an impurity of p type conductivity are implanted, thereby forming a p type semiconductor layer, which is to be p⁺ semiconductor layer 43.

Thereafter, on a region to serve as ridge structure 44 (see Fig. 25), a mask pattern made of a silicon oxide film and in the form of an island is formed. This mask pattern may be adapted to have, for example, a hexagonal planar shape, but may have any other shape (such as a round shape or a quadrangular shape). With this mask pattern formed, portions of p⁺ semiconductor layer 43 and n⁻ epitaxial layer 42 are removed by means of etching. As a result, a projection portion to serve as ridge structure 44 is formed below the mask pattern.

Then, a thermal etching step is performed as with the step illustrated in Fig. 5 in the above-described first embodiment of the present invention, thereby removing the side surface of the projection portion by means of the etching to obtain side surface 20 inclined and shown in Fig. 25. Thereafter, the mask pattern is removed. Further, a resist film having a predetermined pattern is formed to cover the entire structure. This resist film is provided with an opening pattern in conformity with the regions to be guard rings 45. Using the resist film as a mask, an impurity of p type conductivity is implanted into n⁻ epitaxial layer 42. thereby forming guard rings 45. Thereafter, the resist film is removed. After the ion implantation for forming guard rings 45, an activation annealing treatment is performed. In the activation annealing treatment, heat treatment may be performed without forming a cap layer covering at least side surface 20. As a result, the semiconductor device shown in Fig. 25 can be obtained.

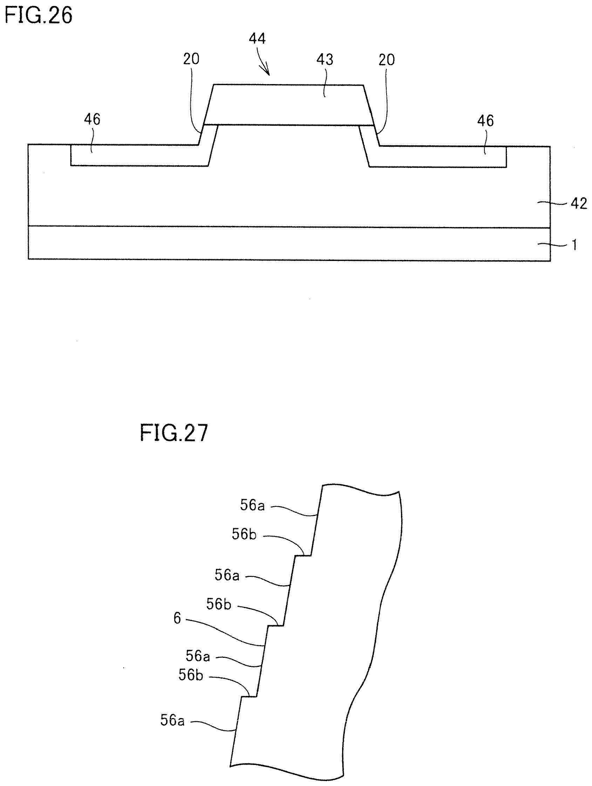

Next, referring to Fig. 26, a variation of the semiconductor device shown in Fig. 25 will be described.

The semiconductor device shown in Fig. 26 has basically the same structure as that of the semiconductor device shown in Fig. 25, but is different therefrom in that a JTE (Junction Termination Extension) region 46 is formed instead of guard rings 45 (see Fig. 25). JTE region 46 is a region of p type conductivity. Such a JTE region 46 can be also formed by performing ion implantation and activation annealing as with those in the formation of guard rings 45 shown in Fig. 25. Then, in the method for manufacturing the semiconductor device shown in Fig. 26, the activation annealing treatment is performed after the ion implantation for forming JTE region 46, without forming a cap layer covering at least side surface 20 as with the method for manufacturing the semiconductor device shown in Fig. 25. Also in this way, side surface 20 is constituted by a stable crystal plane (for example, the {03-3-8} plane). Hence, a problem does not take place, such as side surface 20 having surface roughness resulting from the activation annealing. Further, guard rings 45 shown in Fig. 25 and/or the JET structure shown in and Fig. 26 are applicable to the first embodiment or second embodiment of the present invention

The following describes characteristic configurations of the present invention although some of them have already been described in the above-described embodiments.

In the devices manufactured according to the method of the present invention, side surface 20 of the silicon carbide layer corresponds to substantially the {03-3-8} plane. Hence, side surface 20 corresponding to a semi-polar plane can be used as a channel region (active region) of the semiconductor device. Further, side surface 20 corresponds to the stable crystal plane and therefore achieves high channel mobility. Accordingly, since side surface 20 is employed for the channel region, there can be provided a high-quality semiconductor device exhibiting a higher channel mobility than that in the case of employing other crystal plane (for example, a (0001) plane) for the channel region. Further, side surface 20 is constituted by a plane substantially including the {03-3-8} plane (more specifically, side surface 20 is constituted by a plane substantially equivalent to the (03-3-8) plane). This can suppress a problem of decreasing the channel mobility due to existence of a multiplicity of steps (level difference) in side surface 20 as in the case where the crystal orientation of side surface 20 is deviated relative to the {03-3-8} plane.

Because side surface 20 includes the stable {03-3-8} plane, side surface 20 hardly becomes rough even in the case where side surface 20 is exposed to heat treatment atmosphere in heat treatment such as activation annealing performed after implantation of a conductive impurity. Accordingly, a step of forming a cap layer for protecting side surface 20 during the heat treatment can be omitted.

In the present specification, the case where the side surface of trench 6 includes the {03-3-8} plane encompasses a case where the crystal plane constituting the side surface of trench 6 is the {03-3-8} plane. Further, in the present invention, the {03-3-8} plane also includes a chemically stable plane constituted by, for example, alternately providing a plane 56a (first plane) and a plane 56b (second plane) in the side surface of trench 6 as shown in Fig. 27, microscopically. Plane 56a has a plane orientation of {03-3-8} whereas plane 56b, which is connected to plane 56a, has a plane orientation different from that of plane 56a. Here, the term "microscopically" refers to "minutely to such an extent that at least the size about twice as large as an interatomic spacing is considered". Preferably, plane 56b has a plane orientation of {0-11-1}. Further, plane 56b in Fig. 27 may have a length (width) twice as large as, for example, the interatomic spacing of Si atoms (or C atoms).

Further, each of the mesa structures may have an upper surface continuous to side surface 20 and substantially corresponding to the {000-1} plane. It should be noted that the expression "the surface portion or the upper surface substantially corresponds to the {000-1} plane" refers to a case where the crystal plane constituting the surface portion or the upper surface is the {000-1} plane, and a case where the crystal plane constituting the surface portion or the upper surface is a plane having an off angle of not less than -3° and not more than 3° relative to the {000-1} plane in the <1-100> direction. In this case, the above-described surface portion between the mesa structures (and/or the upper surface of each of the mesa structures) corresponds to the stable {000-1} plane (so-called "just plane"). Hence, even though no cap layer is formed to protect the surface portion (and the upper surface of each of the mesa structures), the surface portion and the upper surface of each of the mesa structures hardly become rough due to heat treatment such as the above-described activation annealing. Thus, the step of forming the cap layer on the surface portion and the upper surface of each of the mesa structures for the heat treatment such as activation annealing can be omitted.

In the semiconductor device, the upper surface of each of the mesa structures continuous to side surface 20 has a hexagonal planar shape as shown in Fig. 1 or Fig. 8. The plurality of mesa structures includes at least three mesa structures. The plurality of mesa structures are arranged such that an equilateral triangle is formed by line segments connecting the respective centers thereof when viewed in a planar view as shown in Fig. 1. In this case, the mesa structures can be arranged most densely, thereby forming a larger number of mesa structures in one substrate 1,31. Hence, semiconductor devices employing the mesa structures can be obtained from one substrate 1,31 as many as possible.

The semiconductor device may include a source electrode 12 formed on the upper surface of each of the mesa structures and a gate electrode 9 formed between the plurality of mesa structures as shown in Fig. 2 or Fig. 15. In this case, the locations of source electrode 12 and gate electrode 9 are such that they are formed relatively readily. Hence, the process of manufacturing the semiconductor device can be restrained from being complicated.

The semiconductor device may further include an electric field relaxing region 7 formed between the plurality of mesa structures. In this case, when drain electrode 14 is formed on the backside surface of substrate 1. 31 (backside surface of substrate 1,31 opposite to its main surface on which silicon carbide is formed), the existence of electric field relaxing region 7 allows for higher breakdown voltage between drain electrode 14 and an electrode located between the mesa structures (for example, gate electrode 9).

A method for manufacturing a semiconductor device according to the present invention includes the steps of: preparing substrate 1, 31 having a main surface on which a silicon carbide layer is formed as shown in Fig. 4 or Fig. 17; forming an end surface (side surface 20) of the silicon carbide layer so as to be inclined relative to the main surface of substrate 1,31 as shown in Fig. 6 and Fig. 7 or Fig. 18 and Fig. 19; forming an insulating film (gate insulating film 8) on side surface 20; and forming a gate electrode 9 on gate insulating film 8. In the step of forming the end surface, the end surface (side surface 20) is formed to substantially include a {03-3-8} plane as set out in claim 1. In this way, the semiconductor device can be manufactured readily. It should be noted that the method for manufacturing the semiconductor device may further include the step of forming a source electrode 12 on the upper surface of each of the mesa structures as shown in Fig. 11 or Fig. 23.

In the step of forming the end surface in the method for manufacturing the semiconductor device, each of the mesa structures is formed to have an upper surface having a hexagonal planar shape as shown in Fig. 8 or the like. In this case, side surface 20 of the mesa structure is substantially constituted only by the {03-3-8} plane. Thus, the entire side surface 20 of the outer circumference of the mesa structure can be used as the channel region, thereby achieving improved degree of integration of semiconductor devices.

The step of forming the end surface in the method for manufacturing the semiconductor device may include the steps of: forming a mask layer 17 as shown in Fig. 5 or Fig. 18; and forming the mesa structures as shown in Fig. 5 and Fig. 6 or Fig. 18 and Fig. 19. In the step of forming mask layer 17, a plurality of mask layers 17 each having a hexagonal planar shape may be formed on the main surface of the silicon carbide layer. In the step of forming the mesa structures, the mesa structures each having its upper surface having a hexagonal planar shape may be formed using mask layers 17 as a mask. In this case, the location of each of the mesa structures to be formed (i.e., the location of side surface 20) can be controlled in accordance with a location of the pattern of mask layers 17. This leads to increased degree of freedom in layout of the semiconductor device to be formed.

The step of forming the end surface in the method for manufacturing the semiconductor device may include the steps of: forming a mask layer 17 as shown in Fig. 5 and Fig. 6 or Fig. 18 and Fig. 19; forming a recess (trench 16 in Fig. 5 or Fig. 18); and forming the mesa structures shown in Fig. 6 or Fig. 19. In the step of forming mask layer 17, a plurality of mask layers 17 each having a hexagonal planar shape may be formed with a space interposed therebetween on the main surface of the silicon carbide layer. In the step of forming the recess (trench 16), a portion of the silicon carbide layer exposed between the plurality of mask layers 17 is removed using mask layers 17 as a mask, thereby forming the recess (trench 16) in the main surface of the silicon carbide layer. In the step of forming the mesa structures, a portion of the side wall of trench 16 may be removed, thereby forming the mesa structures each having an upper surface having a hexagonal planar shape. In this case, it takes a shorter time to remove (for example, thermally etch) a portion of the side wall of trench 16 to form the mesa structures, than that in the case where trench 16 is not formed in advance in the silicon carbide layer using mask layers 17 as a mask.

In the step of forming the end surface in the method for manufacturing the semiconductor device, side surface 20 of the mesa structure may be formed in a spontaneous formation manner. Specifically, by etching the silicon carbide layer under the claimed conditions , namely thermal etching employing a mixed gas of oxygen and chlorine as a reaction gas and employing a heating temperature of not less than 700°C and not more than 1000°C, the {03-3-8} plane, which is a plane allowing for the slowest etching rate during etching, may be exhibited in a spontaneous formation manner. Alternatively, in embodiments not forming part of the present invention, surface to serve as side surface 20 may be formed through normal etching as shown in Fig. 12, and then a silicon film (Si film 21) may be formed on the surface. Then, the silicon carbide layer with Si film 21 is heated to form a SiC reconstitution layer 22 on the surface, thereby forming the above-described {03-3-8} plane accordingly. In this case, the {03-3-8} plane can be stably formed at the side surface 20.

In the step of forming the end surface in the method for manufacturing the semiconductor device, side surface 20 of each of the mesa structures and the surface portion (bottom wall of trench 6) of the silicon carbide layer, which is located between the plurality of mesa structures and is continuous to side surface 20, may be formed in a spontaneous formation manner. Specifically, using the claimed method, the {03-3-8} plane is exhibited at side surface 20 in each of the mesa structures, and the (000-1) is exhibited at the bottom wall of trench 6. In this case, the (000-1) plane can be formed stably at the bottom wall of trench 6 as with each of side surfaces 20.

The method for manufacturing the semiconductor device may include the steps of: implanting a conductive impurity into the silicon carbide layer as shown in Fig. 7 or Fig. 20; and performing heat treatment (activation annealing) for activating the conductive impurity thus implanted. In the step of performing the heat treatment, the surface of the silicon carbide layer may be exposed to an atmospheric gas for the heat treatment. In this case, the process of manufacturing the semiconductor device can be simplified as compared with a case of forming a cap layer or the like on the end surface before the step of performing the heat treatment. Further, in the method for manufacturing the semiconductor device in the present invention, side surface 20 formed in the silicon carbide layer substantially corresponds to the {03-3-8} plane, which is a very stable plane. Hence, even though the end surface is exposed during the heat treatment, failure such as bunching hardly takes place.

Further, a semiconductor device, which is a reference example in the present invention, includes: a substrate 1. 31 having a main surface as shown in Fig. 1, Fig. 2. Fig. 15, Fig. 25, Fig. 26, or the like: and a silicon carbide layer (breakdown voltage holding layer 2, semiconductor layer 3, n type source contact layer 4, and p type contact region 5 in Fig. 2, or n type epitaxial layer 32, p type semiconductor layer 33, n type source contact layer 34, and p type contact region 35 in Fig. 15, or n⁻ epitaxial layer 42 and p⁺ semiconductor layer 43 in Fig. 25 and Fig. 26). The silicon carbide layer is formed on the main surface of substrate 1,31. The silicon carbide layer includes a side surface 20 serving as an end surface inclined relative to the main surface. Side surface 20 substantially includes one of a {03-3-8} plane and a {01-1-4} plane in the case where the silicon carbide layer is of hexagonal crystal type. Side surface 20 substantially includes a {100} plane in the case where the silicon carbide layer is of cubic crystal type.

In this way, side surface 20 formed in the silicon carbide layer substantially corresponds to any one of the {03-3-8} plane, the {01-1-4} plane, and the {100} plane. Hence, side surface 20 corresponding to the so-called "semi-polar plane" can be used as an active region (for example, a channel region) of the semiconductor device.
Because side surface 20 thus corresponds to the stable crystal plane, leakage current can be reduced sufficiently and higher breakdown voltage can be obtained in the case where such a side surface 20 is employed for the active region such as the channel region, as compared with a case where another crystal plane (such as the (0001) plane) is employed for the channel region.

In the semiconductor device, side surface 20 may include an active region as shown in Fig. 2 or Fig. 15. Further, in the semiconductor device, specifically, the active region includes a channel region. In this case, the above-described characteristics such as the reduced leakage current and the high breakdown voltage can be securely obtained.

In the semiconductor device, the silicon carbide layer may have a main surface opposite to its surface facing substrate 1,31 and including a mesa structure having a side surface constituted by side surface 20 described above as shown in Fig. 25 and Fig. 26. In the mesa structure, a PN junction (junction between n⁻ epitaxial layer 42 and p⁺ semiconductor layer 43 in Fig. 25 or Fig. 26) may be formed. In this case, side surface 20 serving as the side wall of the mesa structure corresponds to the above-described crystal plane. Accordingly, leakage current from side surface 20 can be reduced.

In the semiconductor device, as shown in Fig. 26, at least a portion of side surface 20 may constitute a termination structure (JTE region 46). In this case, the leakage current can be reduced in the termination structure formed in side surface 20, and the breakdown voltage in the termination structure can be high.

Further, a non claimed method for manufacturing a semiconductor device in the reference example of the present invention includes the steps of: preparing a substrate 1,31 on which a silicon carbide layer is formed as shown in Fig. 4 or Fig. 17; forming an end surface (side surface 20) in the silicon carbide layer so as to be inclined relative to a main surface thereof as shown in Fig. 6 and Fig. 7 or Fig. 18 and Fig. 19; and forming a structure included in the semiconductor device, using the end surface (side surface 20) as shown in Fig. 7 to Fig. 13 or Fig. 20 to Fig. 23. In the step of forming the end surface (side surface 20), a portion of the main surface of the silicon carbide layer is removed by etching with the silicon carbide layer being heated while exposing the silicon carbide layer to a reaction gas containing oxygen and chlorine. Accordingly, the end surface (side surface 20) inclined relative to the main surface thereof (for example, the upper surface of n type source contact layer 4, 34 in Fig. 6, Fig. 19) is formed in the silicon carbide layer. The end surface (side surface 20) substantially includes one of a {03-3-8} plane and a {01-1-4} plane in the case where the silicon carbide layer is of hexagonal crystal type. Side surface 20 substantially includes a {100} plane in the case where the silicon carbide layer is of cubic crystal type. In this case, the semiconductor device according to the reference example can be readily manufactured.

Further, a method for processing a substrate in the reference example includes the steps of: preparing a substrate 1,31 on which a silicon carbide layer is formed as shown in Fig. 4 or Fig. 17; and forming an end surface (side surface 20) in the silicon carbide layer so as to be inclined relative to the main surface thereof as shown in Fig. 5 and Fig. 6 or Fig. 18 and Fig. 19. In the step of forming the end surface (side surface 20), a portion of the main surface of the silicon carbide layer is removed by etching with the silicon carbide layer being heated while exposing the silicon carbide layer to a reaction gas containing oxygen and chlorine. Accordingly, side surface 20 inclined relative to the main surface is formed in the silicon carbide layer. Side surface 20 substantially includes one of a {03-3-8} plane and a {01-1-4} plane in the case where the silicon carbide layer is of hexagonal crystal type. Side surface 20 substantially includes a {100} plane in the case where the silicon carbide layer is of cubic crystal type. In this case, there can be readily obtained the substrate having the silicon carbide layer formed thereon to have side surface 20 including the above-described crystal plane.

The method for manufacturing the semiconductor device or the method for processing the substrate may further include the step of forming mask layers 17 having a pattern on the main surface of the silicon carbide layer as shown in Fig. 5 or Fig. 18 before the step of forming the end surface (side surface 20). In the step of forming the end surface (side surface 20), etching may be performed using mask layers 17 as a mask. In this case, the location of side surface 20 to be formed can be controlled in accordance with a location of the pattern of mask layers 17. This leads to increased degree of freedom in layout of the semiconductor device to be formed.

Further, it is preferable to remove a portion of the silicon carbide layer in advance by means of the etching employing mask layers 17 as a mask, and thereafter heat the silicon carbide layer while exposing the silicon carbide layer to a reaction gas containing oxygen and chlorine as shown in Fig. 6 or Fig. 19, thereby removing the portion of the main surface of the silicon carbide layer by means of the etching (thermal etching). In this case, it takes a shorter time to thermally etch it to form side surface 20, than that in the case where the above-described etching is not performed in advance using mask layers 17 as a mask.

In the method for manufacturing the semiconductor device or the method for processing the substrate, a ratio of a flow rate of oxygen to a flow rate of chlorine may be not less than 0.25 and not more than 2.0 in the reaction gas used in the step of forming the end surface (side surface 20). In this case, the end surface including the {03-3-8} plane, the {01-1-4} plane, or the {100} plane can be securely formed.

In the step of forming the end surface (side surface 20) in the method for manufacturing the semiconductor device or the method for processing the substrate, the silicon carbide layer may be heated at a temperature of not less than 700°C and not more than 1200°C. Further, the lower limit of the temperature for heating can be 800°C, more preferably, 900°C. Further, the upper limit of the temperature for heating may be more preferably 1100°C, further preferably, 1000°C. In this case, the etching rate can be a sufficiently practical value in the thermal etching step of forming the end surface including the {03-3-8} plane, the {01-1-4} plane, or the {100} plane. Accordingly, the process time in this step can be sufficiently short.

The embodiments disclosed herein are illustrative and non-restrictive in any respect. The scope of the present invention is defined by the terms of the claims, rather than the embodiments described above, and is intended to include any modifications falling within the scope of the invention, which is defined by the appended claims.

### INDUSTRIAL APPLICABILITY

The present invention is particularly advantageously applied to a semiconductor device employing a silicon carbide layer.

### REFERENCE SIGNS LIST

1, 31: substrate: 2: breakdown voltage holding layer; 3: body layer (p type semiconductor layer); 4, 34: n type source contact layer; 5. 35: contact region; 6, 16: trench; 7: electric field relaxing region: 8: gate insulating film; 9: gate electrode; 10: interlayer insulating film; 11: opening; 12: source electrode; 13: source wire electrode; 14: drain electrode; 15: backside surface protecting electrode; 17: mask layer; 20: side surface; 21: Si film; 22: SiC reconstitution layer; 32: n type epitaxial layer; 33: p type semiconductor layer; 36: p type epitaxial layer; 42: n⁻ epitaxial layer; 43: p⁺ semiconductor layer; 44: ridge structure: 45: guard ring; 46: JTE region.

## Claims

1. **A method for manufacturing a semiconductor device comprising** a substrate (1, 31) made of hexagonal crystal type SiC having a main surface; and a silicon carbide layer (2-5, 32-35) of hexagonal crystal type silicon carbide formed on said main surface of said substrate (1, 31) and including an end surface (20) inclined relative to said main surface, said silicon carbide layer (2-5_{,} 32-35) including a plurality of mesa structures at its main surface opposite to its surface facing said substrate (1, 31), and said silicon carbide laver (2-5, 32-35) having a surface portion located between said plurality of mesa structures thereby forming a trench (6) between adjacent mesa structures, continuous to said end surface (20), and corresponding to a {000-1} plane, each of said plurality of mesa structures having an hexagonal planar shape,
said plurality of mesa structures includes at least three mesa structures, and
said plurality of mesa structures are arranged such that an equilateral triangle is formed by line segments connecting respective centers thereof when viewed in a planar view
wherein
each side wall of the mesa structures is constituted by said end surface (20) and substantially includes a {03-3-8} plane, such that the crystal plane constituting the end surface is the {03-3-8} plane, or the crystal plane constituting the end surface (20) is a plane having an off angle of not less than -1° and not more than 1° relative to the {03-3-8} plane in the <1-100> direction,
the off angle is an angle formed by an orthogonal projection of a normal line of the end surface (20) to a flat plane defined by the <1-100> direction and the <0001> direction, and a normal line of the {03-3-8} plane.
the sign of positive value corresponds to a case where the orthogonal projection approaches in parallel with the <1-100> direction whereas the sign of negative value corresponds to a case where the orthogonal projection approaches in parallel with the <0001> direction,
said silicon carbide laver (2-5, 32-35) including an n-type breakdown voltage holding layer (2, 32), for each mesa structure, a body layer (3, 33) having p type conductivity formed on said breakdown voltage holding layer (2, 32), a source contact laver (4, 34) having n type conductivity formed on the body layer (3, 33) , and a contact layer (5, 35) having p-type conductivity formed to be surrounded by the source contact layer (4; 34);
the semiconductor device is a vertical MOSFET or a vertical IGBT, and further comprises:
a gate insulating film (8) in direct contact with the body layer (3, 33) having p type conductivity, the source contact layer (4, 34) having n type conductivity, and the breakdown voltage holding layer (2, 32), and formed on the side walls and the bottom of the trench (6), wherein a channel region is formed on each side wall of the plurality of mesa structures, and
a gate electrode (9) formed on the gate insulating film (8);
the method comprising the steps of:
preparing said substrate (1, 31) _having a main surface on which said silicon carbide layer (2-5, 32-35) of hexagonal crystal type silicon carbide is formed;
forming said end surface (20) by first performing an RIE etch process step forming a recess (16) (16) having a side wall perpendicular to the main surface of substrate (1) followed by a thermal etching in said silicon carbide layer (2-5, 32-35) so as to be inclined relative to the main surface of said substrate (1, 31);
forming said gate insulating film (8) on said end surface (20); and
forming said gate electrode (9) on said gate insulating film (8), wherein thermal etching employs a mixed gas of oxygen and chlorine as a reaction gas,
thermal etching employs a heating temperature of not less than 700°C and not more than 1000°C.

2. The method for manufacturing the semiconductor device according to claim 1, wherein:
the step of forming said end surface (20) includes the steps off forming a plurality of mask layers (17), each of which has a hexagonal planar shape, on the main surface of said silicon carbide layer (2-5, 32-35), and
forming said mesa structures each having said upper surface having the hexagonal planar shape, using said mask layers (17) as a mask.

3. The method for manufacturing the semiconductor device according to claim 1, wherein:
the step of forming said end surface (20) includes the steps of
forming a plurality of mask layers (17), each of which has a hexagonal planar shape, with a space interposed therebetween on the main surface of said silicon carbide layer (2-5, 32-35), by means of said RIE process step, forming said recess (16) in the main surface of said silicon carbide layer (2-5, 32-35) by removing, using said mask layers (17) as a mask, a portion of said silicon carbide layer (2-5, 32-35) exposed between said plurality of mask layers (17), and
by means of said thermal etching process step, forming said mesa structures each having the upper surface having the hexagonal planar shape, by removing a portion of a side wall of said recess (16).

4. The method for manufacturing the semiconductor device according to claim 1, wherein in the step of forming said end surface (20), said side surface of each of said mesa structures is formed in a spontaneous formation manner.

5. The method for manufacturing the semiconductor device according to claim 1, wherein in the step of forming said end surface (20), said side surface of each of said mesa structures and a surface portion of said silicon carbide layer (2-5, 32-35) located between said plurality of mesa structures and continuous to said side surface are formed in a spontaneous formation manner.

6. The method for manufacturing the semiconductor device according to claim 1, further comprising the steps of:
implanting a conductive impurity into said silicon carbide layer (2-5, 32-35); and
performing heat treatment for activating said conductive impurity thus implanted, wherein
in the step of performing said heat treatment, a surface of said silicon carbide layer (2-5, 32-35) is exposed to an atmospheric gas for the heat treatment.

## Patentansprüche

1. Verfahren zur Herstellung einer Halbleitervorrichtung, umfassend:
ein Substrat (1, 31) aus hexagonalem SiC-Kristall mit einer Hauptfläche; und
eine Siliziumkarbidschicht (2-5, 32-35) aus hexagonalem Siliziumkarbid-Kristall, die auf der Hauptfläche des Substrats (1, 31) ausgebildet ist und eine relativ zur Hauptfläche geneigte Endfläche (20) aufweist, wobei
die Siliziumkarbidschicht (2-5, 32-35) eine Vielzahl von Mesa-Strukturen auf ihrer Hauptfläche gegenüber ihrer dem Substrat (1, 31) zugewandten Oberfläche aufweist, und die Siliziumkarbidschicht (2-5, 32-35) einen zwischen der Vielzahl von Mesa-Strukturen angeordneten Oberflächenabschnitt aufweist, wodurch ein Graben (6) zwischen benachbarten Mesa-Strukturen gebildet wird, der sich an die Endfläche (20) anschließt und einer {000-1}-Ebene entspricht, wobei jede der Vielzahl von Mesa-Strukturen eine hexagonale ebene Form aufweist,
die Vielzahl von Mesa-Strukturen mindestens drei Mesa-Strukturen umfasst, und
die Vielzahl von Mesa-Strukturen so angeordnet ist, dass ein gleichseitiges Dreieck durch Liniensegmente gebildet wird, die deren jeweilige Mittelpunkte in einer ebenen Ansicht verbinden, wobei
jede Seitenwand der Mesa-Strukturen durch die Endfläche (20) gebildet wird und im Wesentlichen eine {03-3-8}-Ebene umfasst, so dass die Kristallebene, die die Endfläche bildet, die {03-3-8}-Ebene ist, oder die Kristallebene, die die Endfläche (20) bildet, eine Ebene mit einem Abweichungswinkel von nicht weniger als-1° und nicht mehr als 1° relativ zur {03-3-8}-Ebene in der <1-100>-Richtung ist,
der Abweichungswinkel ein Winkel ist, der durch eine orthogonale Projektion einer Normalen der Endfläche (20) auf eine ebene Ebene, die durch die <1-100>-Richtung und die <0001>-Richtung definiert ist, und eine Normale der {03-3-8}-Ebene gebildet wird,
das Vorzeichen mit positivem Wert einem Fall entspricht, in dem sich die orthogonale Projektion parallel zur <1-100>-Richtung nähert, während das Vorzeichen mit negativem Wert einem Fall entspricht, in dem sich die orthogonale Projektion parallel zur <0001>-Richtung nähert,
die Siliziumkarbidschicht (2-5, 32-35) eine n-Durchbruchsspannungs-Halteschicht (2, 32) für jede Mesa-Struktur, eine Körperschicht (3, 33) mit p-Leitfähigkeit, die auf der Durchbruchsspannungs-Halteschicht (2, 32) gebildet ist, eine Source-Kontaktschicht (4, 34) mit n-Leitfähigkeit, die auf der Körperschicht (3, 33) gebildet ist, und eine Kontaktschicht (5, 35) mit p-Leitfähigkeit, die so gebildet ist, dass sie von der Source-Kontaktschicht (4, 34) umgeben ist, enthält;
die Halbleitervorrichtung ein vertikaler MOSFET oder ein vertikaler IGBT ist und ferner umfasst:
einen Gate-Isolierfilm (8), der in direktem Kontakt mit der Körperschicht (3, 33) mit p-Leitfähigkeit, der Source-Kontaktschicht (4, 34) mit n-Leitfähigkeit und der Durchbruchsspannungs-Halteschicht (2, 32) steht und auf den Seitenwänden und dem Boden des Grabens (6) ausgebildet ist, wobei ein Kanalgebiet an jeder Seitenwand der Vielzahl von Mesa-Strukturen ausgebildet ist, und
eine Gate-Elektrode (9), die auf dem Gate-Isolierfilm (8) ausgebildet ist;
wobei das Verfahren die folgenden Schritte umfasst:
Herstellen des Substrats (1, 31) mit einer Hauptfläche, auf der die Siliziumkarbidschicht (2-5, 32-35) aus hexagonalem Siliziumkarbid-Kristall gebildet wird;
Bilden der Endfläche (20), indem zuerst ein RIE-Ätzprozessschritt durchgeführt wird, der eine Vertiefung (16) mit einer Seitenwand senkrecht zur Hauptfläche (1) bildet, gefolgt von einem thermischen Ätzen in der Siliziumkarbidschicht (2-5, 32-35), so dass sie relativ zur Hauptfläche des Substrats (1, 31) geneigt ist;
Bilden des Gate-Isolierfilms (8) auf der Endfläche (20); und
Bilden der Gate-Elektrode (9) auf dem Gate-Isolierfilm (8), wobei
beim thermischen Ätzen ein Mischgas aus Sauerstoff und Chlor als Reaktionsgas verwendet wird,
beim thermischen Ätzen eine Heiztemperatur von nicht weniger als 700°C und nicht mehr als 1000°C verwendet wird.

2. Verfahren zur Herstellung der Halbleitervorrichtung nach Anspruch 1, wobei der Schritt des Bildens der Endfläche (20) die folgenden Schritte umfasst:
Bilden einer Vielzahl von Maskenschichten (17), von denen jede eine hexagonale ebene Form hat, auf der Hauptfläche der Siliziumkarbidschicht (2-5, 32-35), und
Bilden der Mesa-Strukturen, die jeweils die obere Fläche mit der hexagonalen ebenen Form aufweisen, unter Verwendung der Maskenschichten (17) als Maske.

3. Verfahren zur Herstellung der Halbleitervorrichtung nach Anspruch 1, wobei der Schritt des Bildens der Endfläche (20) die folgenden Schritte umfasst:
Bilden einer Vielzahl von Maskenschichten (17), von denen jede eine sechseckige ebene Form hat, mit einem dazwischenliegenden Zwischenraum auf der Hauptfläche der Siliziumkarbidschicht (2-5, 32-35),
Ausbilden der Vertiefung (16) in der Hauptfläche der Siliziumkarbidschicht (2-5, 32-35) mittels des RIE-Verfahrensschritts durch Entfernen eines Teils der Siliziumkarbidschicht (2-5, 32-35), der zwischen der Vielzahl von Maskenschichten (17) freiliegt, unter Verwendung der Maskenschichten (17) als Maske, und
Bilden der Mesa-Strukturen, mittels des thermischen Ätzverfahrensschrittes, von denen jede die obere Fläche mit der sechseckigen ebenen Form aufweist, durch Entfernen eines Teils einer Seitenwand der Vertiefung (16).

4. Verfahren zur Herstellung der Halbleitervorrichtung nach Anspruch 1, wobei in dem Schritt des Bildens der Endfläche (20) die Seitenfläche jeder der Mesa-Strukturen durch spontanes Ausbilden gebildet wird.

5. Verfahren zur Herstellung der Halbleitervorrichtung nach Anspruch 1, wobei in dem Schritt des Bildens der Endfläche (20) die Seitenfläche jeder der Mesa-Strukturen und ein Oberflächenabschnitt der Siliziumkarbidschicht (2-5, 32-35), der sich zwischen der Vielzahl von Mesa-Strukturen befindet und an die Seitenfläche angrenzt, durch spontanes Ausbilden gebildet werden.

6. Verfahren zur Herstellung der Halbleitervorrichtung nach Anspruch 1, das ferner die folgenden Schritte umfasst::
Implantieren einer leitfähigen Verunreinigung in die Siliziumkarbidschicht (2-5, 32-35); und
Durchführen einer Wärmebehandlung zum Aktivieren der so implantierten leitfähigen Verunreinigung, wobei
in dem Schritt der Durchführung der Wärmebehandlung eine Oberfläche der Siliziumkarbidschicht (2-5, 32-35) einem atmosphärischen Gas für die Wärmebehandlung ausgesetzt wird.

## Revendications

1. Procédé de fabrication d'un dispositif semi-conducteur comprenant
un substrat (1, 31) formé de carbure de silicium (SiC) à cristaux hexagonaux ayant une surface principale ; et
une couche de carbure de silicium (2-5, 32-35) en carbure de silicium à cristaux hexagonaux formée sur ladite surface principale dudit substrat (1, 31) et incluant une surface d'extrémité (20) inclinée par rapport à ladite surface principale,
ladite couche de carbure de silicium (2-5, 32-35) comprenant une pluralité de structures mesa au niveau de sa surface principale opposée à sa surface située du côté dudit substrat (1, 31), et ladite couche de carbure de silicium (2-5, 32-35) ayant une partie de surface située entre ladite pluralité de structures mesa, formant ainsi une tranchée (6) entre des structures mesa adjacentes, continue à ladite surface d'extrémité (20), et correspondant à un plan {000-1}, chacune de ladite pluralité de structures mesa ayant une forme plane hexagonale,
ladite pluralité de structures mesa comprend au moins trois structures mesa, et
ladite pluralité de structures mesa est agencée de sorte qu'un triangle équilatéral est formé par les segments de droite reliant leurs centres respectifs, en vue plane, dans lequel
chaque paroi latérale des structures mesa est constituée par ladite surface d'extrémité (20) et inclut essentiellement un plan {03-3-8}, de sorte que le plan cristallin constituant la surface d'extrémité est le plan {03-3-8}, ou le plan cristallin constituant la surface d'extrémité (20) est un plan présentant un angle de décalage supérieur à -1 ° et inférieur à 1° par rapport au plan {03-3-8} dans la direction <1-100>,
l'angle de décalage est un angle formé par une projection orthogonale d'une droite normale de la surface d'extrémité (20) par rapport à un plan plat défini par la direction <1-100> et la direction <0001>, et une droite normale du plan {03-3-8},
le signe de valeur positive correspond à un cas où la projection orthogonale est parallèlement proche de la direction <1-100>, tandis que le signe de valeur négative correspond à un cas où la projection orthogonale est parallèlement proche de la direction <0001>,
ladite couche de carbure de silicium (2-5, 32-35) incluant une couche de tenue en tension de claquage de type n (2, 32), pour chaque structure mesa, une couche formant corps (3, 33) ayant une conductivité de type p formée sur ladite couche de tenue en tension de claquage (2, 32), une couche de contact source (4, 34) ayant une conductivité de type n formée sur la couche formant corps (3, 33), et une couche de contact (5, 35) ayant une conductivité de type p formée de manière à être entourée par la couche de contact source (4, 34) ;
le dispositif semi-conducteur est un MOSFET vertical ou un IGBT vertical, et comprend en outre :
un film d'isolation de grille (8) en contact direct avec la couche formant corps (3, 33) ayant une conductivité de type p, la couche de contact source (4, 34) ayant une conductivité de type n, et la couche de tenue en tension de claquage (2, 32), et formé sur les parois latérales et le fond de la tranchée (6), dans lequel une région canal est formée sur chaque paroi latérale de la pluralité de structures mesa, et
une électrode de grille (9) formée sur le film d'isolation de grille (8) ;
le procédé comprenant les étapes de :
préparation dudit substrat (1, 31) ayant une surface principale sur laquelle ladite couche de carbure de silicium (2-5, 32-35) en carbure de silicium à cristaux hexagonaux est formée ;
formation de ladite surface d'extrémité (20) en réalisant d'abord une étape de procédé de gravure RIE formant une cavité (16) ayant une paroi latérale perpendiculaire à la surface principale du substrat (1), suivie d'une gravure thermique dans ladite couche de carbure de silicium (2-5, 32-35) de manière à ce qu'elle soit inclinée par rapport à la surface principale dudit substrat (1, 31) ;
formation dudit film d'isolation de grille (8) sur ladite surface d'extrémité (20) ; et
formation de ladite électrode de grille (9) sur ledit film d'isolation de grille (8),
dans lequel
la gravure thermique utilise comme gaz de réaction un mélange gazeux d'oxygène et de chlore,
la gravure thermique utilise une température de chauffage supérieure à 700°C et inférieure à 1 000°C.

2. Procédé de fabrication du dispositif semi-conducteur selon la revendication 1, dans lequel :
l'étape de formation de ladite surface d'extrémité (20) comprend les étapes de
formation d'une pluralité de couches de masque (17), chacune ayant une forme plane hexagonale, sur la surface principale de ladite couche de carbure de silicium (2-5, 32-35), et
formation desdites structures mesa, chacune comprenant ladite surface supérieure ayant la forme plane hexagonale, en utilisant lesdites couches de masque (17) en tant que masque.

3. Procédé de fabrication du dispositif semi-conducteur selon la revendication 1, dans lequel :
l'étape de formation de ladite surface d'extrémité (20) comprend les étapes de
formation d'une pluralité de couches de masque (17), chacune ayant une forme plane hexagonale, présentant un espace interposé entre elles sur la surface principale de ladite couche de carbure de silicium (2-5, 32-35) au moyen de ladite étape de procédé RIE,
formation de ladite cavité (16) dans la surface principale de ladite couche de carbure de silicium (2-5, 32-35) par élimination, en utilisant lesdites couches de masque (17) en tant que masque, d'une partie de ladite couche de carbure de silicium (2-5, 32-35) exposée entre ladite pluralité de couches de masque (17), et
au moyen de ladite étape de procédé de gravure thermique, formation desdites structures mesa, chacune comprenant la surface supérieure ayant la forme plane hexagonale, par élimination d'une partie d'une paroi latérale de ladite cavité (16).

4. Procédé de fabrication du dispositif semi-conducteur selon la revendication 1, dans lequel, dans l'étape de formation de ladite surface d'extrémité (20), ladite surface latérale de chacune desdites structures mesa est formée en tant que formation spontanée.

5. Procédé de fabrication du dispositif semi-conducteur selon la revendication 1, dans lequel, dans l'étape de formation de ladite surface d'extrémité (20), ladite surface latérale de chacune desdites structures mesa et une partie de surface de ladite couche de carbure de silicium (2-5, 32-35) située entre ladite pluralité de structures mesa et continue avec ladite surface latérale sont formées en tant que formations spontanées.

6. Procédé de fabrication du dispositif semi-conducteur selon la revendication 1, comprenant en outre les étapes de :
implantation d'une impureté conductrice dans ladite couche de carbure de silicium (2-5, 32-35) ; et
réalisation d'un traitement thermique pour activer ladite impureté conductrice ainsi implantée, dans lequel
dans l'étape de réalisation dudit traitement thermique, une surface de ladite couche de carbure de silicium (2-5, 32-35) est exposée à un gaz atmosphérique pendant le traitement thermique.
